# EUROPEAN PATENT APPLICATION

(11) **EP 4 794 512 A1**
(43) Date of publication of application: **19.08.2026**
(21) Application number: 26157613.6
(22) Date of filing: 10.02.2026
(51) Int. Cl.: H10W 40/73, H10W 40/22, H10W 40/20, H10W 40/25

(54) **VAPOR CHAMBER FOR SEMICONDUCTOR PACKAGE MODULE AND SEMICONDUCTOR PACKAGE MODULE AND POWER CONVERSION DEVICE INCLUDING THE SAME**

(30) Priority: 12.02.2025 KR 20250017755
(71) Applicant: LX Semicon Co., Ltd., Daejeon 34027 (KR)
(72) Inventor: CHOI, Hyung Kyu, 34027 Daejeon (KR)
(74) Representative: Ter Meer Steinmeister & Partner

(57) **Abstract**

The embodiments relate to a vapor chamber for a semiconductor package module, a semiconductor package module including the same, and a power conversion device. A vapor chamber for a semiconductor package module according to an embodiment may include a lower metal plate, a middle metal plate, and an upper metal plate, which are disposed sequentially. A hollow structure may be disposed within the middle metal plate. And the lower metal plate may include a first plate, a second plate, and a third plate, which are disposed sequentially. And a thermal expansion coefficient of the second plate may be less than a thermal expansion coefficient of the first plate or the third plate.

## Description

### BACKGROUND

### Field of the Disclosure

The embodiment relates to a vapor chamber for semiconductor package module and a semiconductor package module and a power conversion device including the same.

### Description of the Background

As the performance of electric and electronic products progresses, semiconductor packages in which multiple semiconductor devices are disposed on a circuit board are utilized, and semiconductor packages have the advantage of efficiently using the mounting area of semiconductor devices and transmitting high-speed signals through a short signal transmission path between semiconductor devices.

Meanwhile, one of the industries with the fastest growth rate in the semiconductor market recently is the field of data sensor technology using AI semiconductors, and in data centers, the use of AI semiconductors that consume incomparably high power compared to the past is increasing, so interest in heat dissipation technology of semiconductor packages is very high.

Accordingly, the semiconductor and package market in the data center field, which is currently undergoing high growth, is applying many new technologies to secure heat dissipation technology.

In addition, 1200V, 200A high-voltage/high-power SiC power conversion modules are being used to improve the performance of hybrid and electric vehicles and for autonomous vehicles. During the operation of these high-performance electric vehicles, the operating temperature of the power semiconductor devices must be implemented at an average of 300°C or higher, and the maximum instantaneous operating temperature is 350°C to 700°C, which is an ultra-high temperature usage state.

In these ultra-high temperature, high voltage, and high current operating environments, the existing bonding materials themselves may be re-melted, and the heat trap phenomenon may occur due to the pores present in the bonding area, which may rapidly deteriorate the life of the power semiconductor module, and cause thermal runaway, which may lead to the destruction of the power semiconductor devices and seriously affect the safety of the driver.

Recently, various heat dissipation components and heat dissipation modules such as heat sinks, heat dissipation plates, heat pipes, and vapor chambers are being studied to solve the heat generation problem of electronic devices such as AI semiconductors and power semiconductor modules.

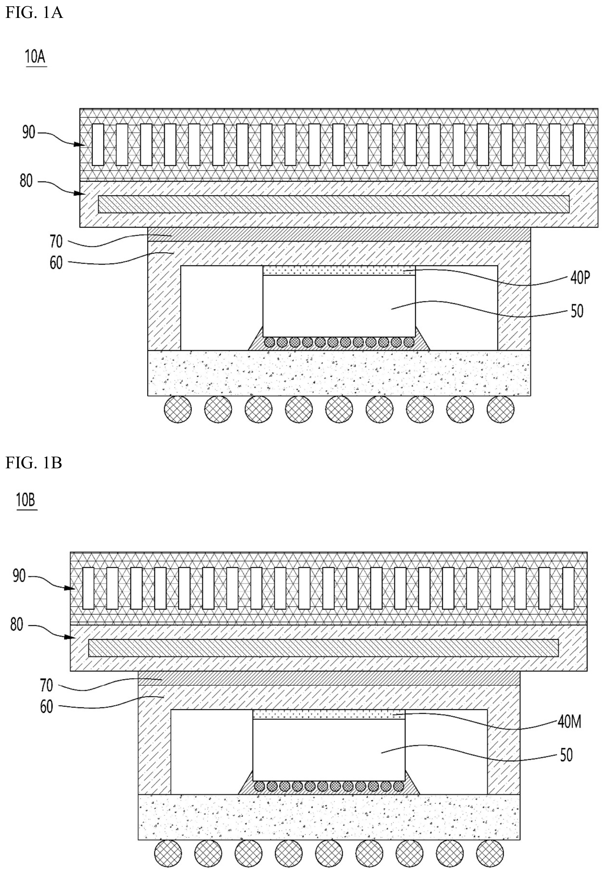

FIG. 1A is a drawing of a semiconductor package module 10A of the first comparative example including a vapor chamber being studied internally.

The semiconductor package module 10A of the first comparative example may include an electronic device 50, a metal lid 60, a vapor chamber 80, and a heat sink 90. In order to release heat generated from the electronic device 50 upward, a metal lid 60 is disposed on the electronic device 50, and the electronic device 50 and the metal lid 60 may be bonded by a first-first adhesive layer 40P.

In addition, a vapor chamber 80 and a heat sink 90 are disposed on the metal lid 60, and the metal lid 60 and the vapor chamber 80 can be bonded with a second adhesive layer 70.

Meanwhile, in the semiconductor package module 10A of the first comparative example, the first-first adhesive layer 40P is formed of a polymer-based material.

However, the first-first adhesive layer 40P of the polymer-based material has a low thermal conductivity, so that the heat generated from the electronic device 50 does not spread and is concentrated in the center, which reduces the heat dissipation efficiency. Accordingly, the semiconductor package module 10A of the first comparative example has a problem in that the temperature of the electronic device 50 increases, so the driving power is lowered to down the temperature of the electronic device 50 itself, and the performance is reduced to 30% or less.

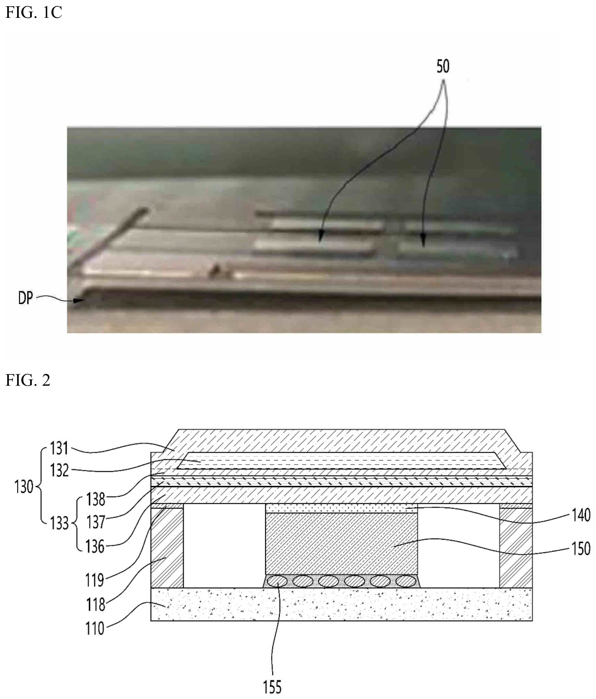

Next, FIG. 1B is a drawing of a semiconductor package module 10B of the second comparative example including a vapor chamber to be studied internally, and FIG. 1C is a photograph of a delamination problem DP in the semiconductor package module 10B of the second comparative example.

Unlike the first comparative example, in the semiconductor package module 10B of the second comparative example, a method of forming the first-second adhesive layer 40M with a metal material was studied to improve the efficiency of transferring heat generated from the electronic device 50 upward. However, there is a difference in the coefficient of thermal expansion between the metal lid 60 and the electronic device 50, and when the temperature of the electronic device 50 increases rapidly, warpage occurs, which causes cracks and voids to occur in the first-second adhesive layer 40M, resulting in a problem DP of delamination in the first-second adhesive layer 40M.

Accordingly, existing technologies attempt to employ a metal adhesive layer to efficiently transfer heat generated from electronic devices upward, but face the problem of a technical contradiction in which delamination occurs in the metal adhesive layer due to a difference in thermal expansion coefficient.

### SUMMARY

Accordingly, the present disclosure is directed to a vapor chamber for semiconductor package module and a semiconductor package module and power conversion device including the same that substantially obviates one or more of problems due to limitations and disadvantages described above.

One of the technical objects of the embodiment is to solve a problem of a technical contradiction in which delamination occurs in the metal adhesive layer due to a difference in thermal expansion coefficient while efficiently transferring heat generated from electronic devices upward by using a metal adhesive layer. In addition, one of the technical objects of the embodiment is to further improve the heat dissipation performance of the vapor chamber.

The technical objects are solved by the features of the independent claims and the embodiments are not limited to those described in this item, and include those that can be understood through the description of the invention.

A vapor chamber for a semiconductor package module according to an embodiment may include a lower metal plate 133, a middle metal plate 132, and an upper metal plate 131 disposed sequentially. A hollow structure 135 may be disposed within the middle metal plate 132. And the lower metal plate 133 may include a first plate 136, a second plate 137, and a third plate 138 disposed sequentially.

A thermal expansion coefficient of the second plate 137 may be less than a thermal expansion coefficient of the first plate 136 or the third plate 138.

The thickness of the hollow structure 135 may be the same as the thickness of the middle metal plate 132.

The upper metal plate 131 and the lower metal plate 133 may include a flat shape.

The embodiment may include a plurality of first fins 145-1 disposed on the upper metal plate 131.

The height of each of the plurality of first fins 145-1 may include different heights.

The height of the first fin 145-1 located at the center of the upper metal plate 131 may be lower than the height of the first fin 145-1 located at the outer portion of the upper metal plate 131.

The plurality of first fins 145-1 may include a concave portion 147 that is concave toward the upper metal plate 131.

The thickness of the first plate 136 may be greater than the thickness of the third plate 138.

The lower metal plate 133 may further include a thermal conductive plug 142 disposed within the second plate 137.

A semiconductor package module including a vapor chamber according to an embodiment may include a substrate 110; an electronic device 150 disposed on the substrate 110; a vapor chamber 130 disposed on the electronic device 150; and a first adhesive layer 140 disposed between the electronic device 150 and the vapor chamber 130. The vapor chamber 130 may include any one of the vapor chambers.

The first adhesive layer 140 may include a metal material.

The embodiment can solve the problem of a technical contradiction in which heat generated from an electronic device is efficiently transferred upward by using a metal adhesive layer while delamination occurs in the metal adhesive layer due to a difference in thermal expansion coefficient.

For example, referring to FIG. 2, the embodiment has a special technical effect that can solve the problem of technical contradiction that delamination occurs in the metal adhesive layer due to the difference in thermal expansion coefficient by controlling the coefficient of thermal expansion of the lower metal plate 133 of the vapor chamber 130 in contact with the electronic device 150 while efficiently transferring heat generated from the electronic device upward by using a metal adhesive layer including a metal material as the first adhesive layer 140.

In addition, according to the embodiment, when manufacturing the vapor chamber 130, a material capable of reducing the difference in thermal expansion coefficient CTE at the surface in contact with the electronic device 150 is included, and due to the reduction in the difference in thermal expansion coefficient, deformation between the electronic device and the vapor chamber 130 due to temperature change can be minimized, thereby significantly improving reliability and heat dissipation efficiency by using a metal adhesive layer with high hardness and high thermal conductivity without delamination.

In addition, the embodiment has a technical effect that can further improve the heat dissipation performance of the vapor chamber.

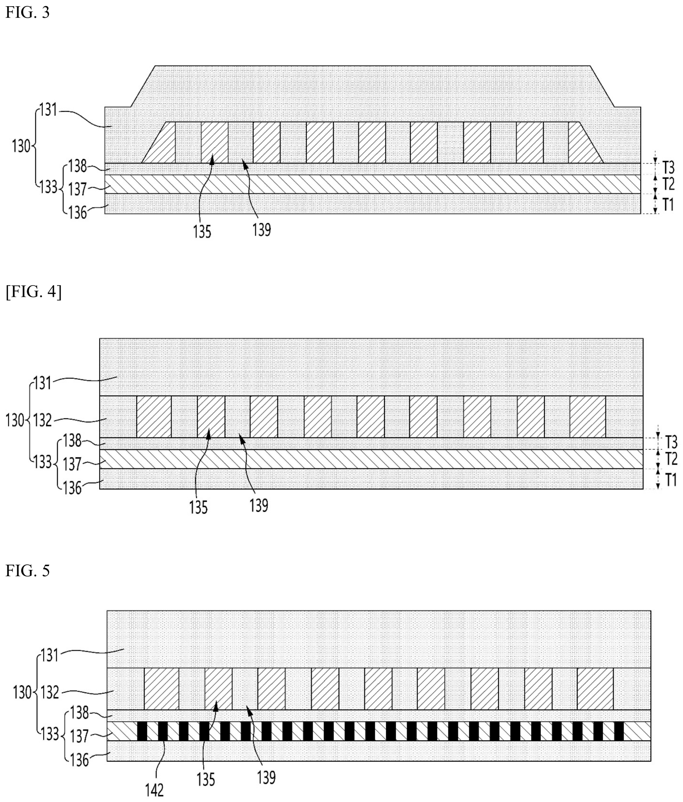

For example, referring to FIG. 5, the embodiment can efficiently transfer heat generated from the electronic device from the first plate 136 to the third plate 138 through the second plate 137 and the heat conductive plug 142 by arranging the thermal conductive plug 142 in the second plate 137. And since the second plate 137 may include a material having a lower thermal expansion coefficient than the first plate 136 and the third plate 138, the thermal deformation of the vapor chamber can be minimized due to the reduction in the thermal expansion coefficient difference, and the reliability and heat dissipation performance can be further improved.

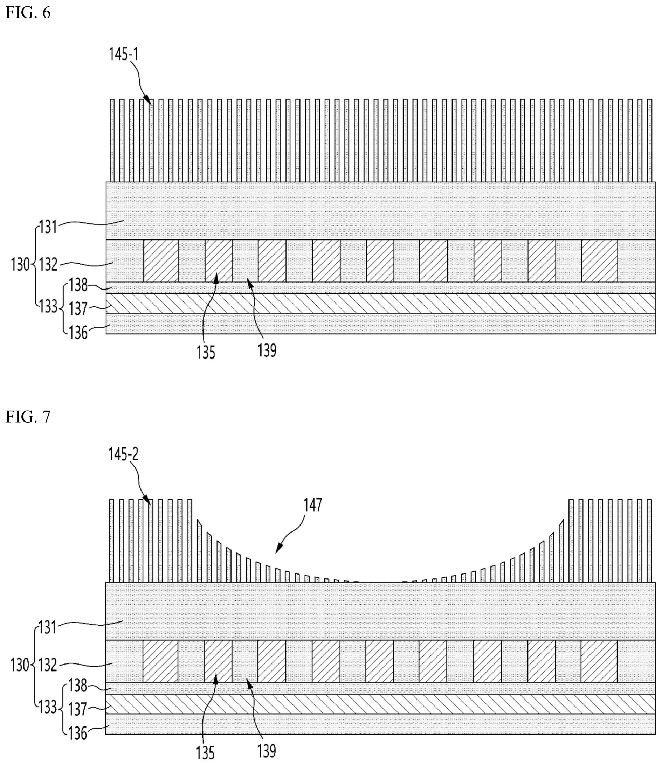

In addition, referring to FIG. 6, the embodiment can effectively release heat by increasing the cross-sectional area of the vapor chamber by arranging the first fin 145-1 extending upward on the upper metal plate 131.

In addition, referring to FIG. 7, the heights of the second fins 145-2 disposed on the upper metal plate 131 may be formed differently to control the heat dissipation performance of the vapor chamber, and the area adjacent to the electronic device can have less heat dissipation performance controlled to actively vaporize the working fluid, and the heat dissipation performance can be improved at both ends of the vapor chamber 130 to actively condense the vaporized working fluid, thereby promoting the convection phenomenon of the fluid within the vapor chamber 130, thereby improving the heat dissipation performance.

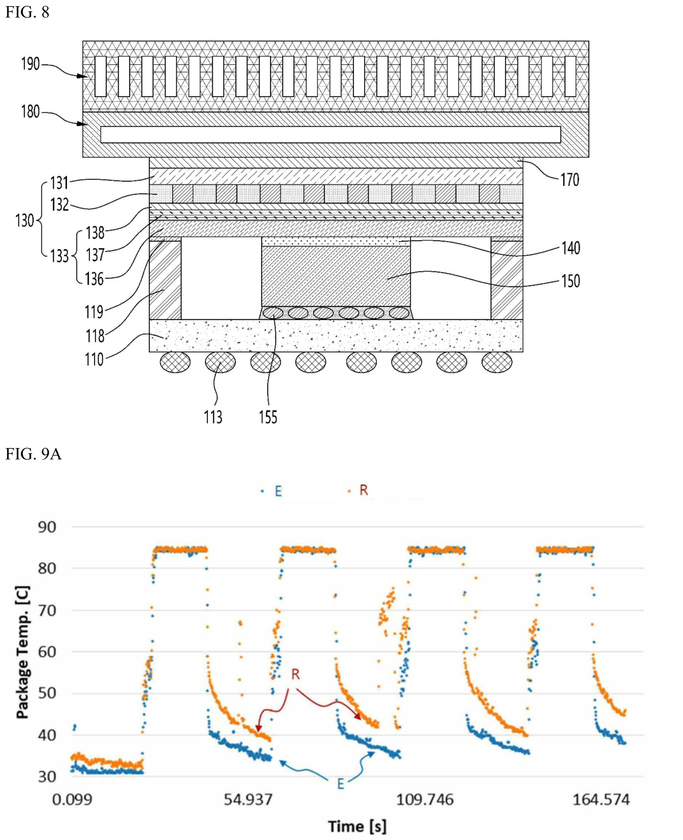

In addition, referring to FIG. 9A, the embodiment E has a technical effect that the heat dissipation performance can be significantly improved, so that the temperature of the semiconductor chip is maintained lower, and even when the temperature is increased for operation, the vapor chamber according to the embodiment can be lowered to a lower temperature more quickly.

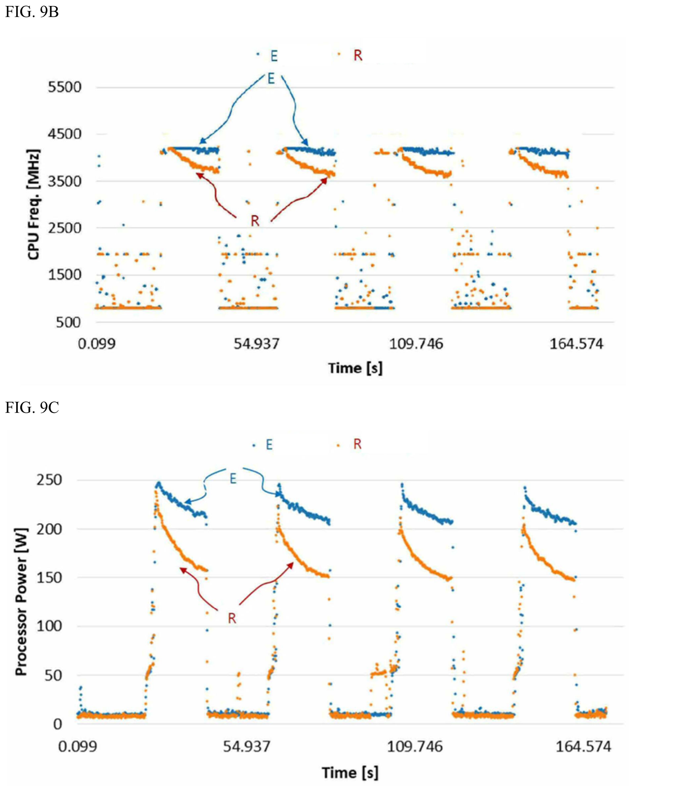

In addition, when the embodiment E and the comparative example R reach the same temperature during operation of the CPU chip, the embodiment E has a special technical effect that it can exhibit higher performance and higher efficiency by expressing a higher clock frequency and power consumption while maintaining the same operating temperature due to the very efficient heat dissipation efficiency as shown in FIG. 9B and FIG. 9C.

For example, referring to FIG. 9B, in the case of Comparative Example R, since the heat dissipation efficiency is low, the clock frequency of the CPU chip is lowered in order to extend the life of the CPU chip, and in Comparative Example R, the decrease in clock frequency is large, so there is a problem that the performance of the CPU chip is significantly reduced.

On the other hand, in the case of Embodiment E, when the semiconductor package module including the vapor chamber according to the embodiment is applied, the heat dissipation performance can be significantly improved, so that the decrease in clock frequency of the CPU chip is almost zero or very small compared to Comparative Example R, and therefore, there is a special technical effect that can maximize the performance of the CPU chip.

Also, referring to FIG. 9C, in the case of Comparative Example R, since the heat dissipation efficiency is low, the power of the CPU chip is lowered in order to extend the life of the CPU chip, and in this case, in Comparative Example R, the decrease in processor power is very large, so there is a problem that the performance of the CPU chip is significantly reduced.

On the other hand, the embodiment E has a special technical effect that can maintain high performance of the CPU chip because the heat dissipation performance can be significantly improved when the semiconductor package module including the vapor chamber is applied, and the decrease in power consumption over time is much less than that of the comparative example R.

The technical effects of the embodiment are not limited to those described in this item, and include those that can be understood through the description of the invention.

### BRIEF DESCRIPTION OF THE DRAWINGS

The accompanying drawings, which are included to provide a further understanding of the disclosure and are incorporated in and constitute a part of the disclosure, illustrate aspects of the disclosure and together with the description serve to explain the principle of the disclosure.
The drawings show:
FIG. 1A a semiconductor package module 10A of the first comparative example including an internally studied vapor chamber.
FIG. 1B a semiconductor package module 10B of the second comparative example including an internally studied vapor chamber. FIG. 1C is a photograph of a delamination problem DP in the semiconductor package module 10B of the second comparative example.
FIG. 2 a cross-sectional view of a semiconductor package module including a vapor chamber for a semiconductor package module according to the embodiment.
FIG. 3 a detailed drawing of a vapor chamber for a semiconductor package module according to the embodiment of FIG. 2.
FIG.4 a vapor chamber for a semiconductor package module of the second embodiment.
FIG. 5 a vapor chamber for a semiconductor package module according to the third embodiment.
FIG. 6 a vapor chamber for a semiconductor package module according to the fourth embodiment.
FIG. 7 a vapor chamber for a semiconductor package module according to the fifth embodiment.
FIG. 8 a semiconductor package module including a vapor chamber for a semiconductor package module according to the sixth embodiment.
FIGS. 9A to 9C are graphs showing the package temperature, the operating frequency of the CPU chip, and the power consumption of the processor over time for the embodiment E and the comparative example R, respectively.

### DETAILED DESCRIPTION

Hereinafter, the aspects disclosed in this specification will be described in detail with reference to the attached drawings. The suffixes 'module' and 'part' used for elements in the following description are given or used interchangeably in consideration of the ease of writing the specification, and do not have distinct meanings or roles in themselves. In addition, the attached drawings are intended to facilitate easy understanding of the aspects disclosed in this specification, and the technical ideas disclosed in this specification are not limited by the attached drawings. In addition, when an element such as a layer, region, or substrate is mentioned as existing 'on' another element, this may include that it may be directly on the other element, or that other intermediate elements may exist in between.

In the specification or claims, the meaning of "an element A may include at least one of a, b, and/or c" may include ① when the element A may include the element a, ② when the element A may include the element b, ③ when the element A may include the element c, ④ when the element A may include the elements a and b, ⑤ when the element A may include the elements b and c, ⑥ when the element A may include the elements a and c, and ⑦ when the element A may include all elements of a, b, and c. The singular expression may include the plural expression as well as the singular expression, unless the context clearly indicates otherwise. For example, the meaning of "element A may include one structure" may include the meaning of "element A may include one or more structures.

### Example

FIG. 2 is a cross-sectional view of a semiconductor package module including a vapor chamber for a semiconductor package module according to an embodiment. Hereinafter, 'semiconductor package module including a vapor chamber for a semiconductor package module' will be abbreviated as 'semiconductor package module'.

Referring to FIG. 2, the semiconductor package module according to the embodiment may include a substrate 110, an electronic device 150, and a vapor chamber 130. In detail, the substrate 110 may include at least one of a plurality of insulating layers, wiring layers, and via electrodes. The substrate 110 may be a semiconductor package substrate. The semiconductor package to which the embodiment is applied may be one of FC-BGA Flip Chip Ball Grid Array), CSP (Chip Scale Package), FC-CSP (Flip Chip-Chip Scale Package), POP (Package On Package), and SIP (System In Package), but is not limited thereto.

The substrate 110 may further include an interposer substrate (not shown to mount an electronic device 150 on the interposer substrate, but is not limited thereto.

In addition, the electronic device 150 may be a semiconductor device. For example, the electronic device 150 may be a high-performance semiconductor such as an AI semiconductor, a processor for a data center, a power semiconductor for an electric vehicle inverter, and the like, but is not limited thereto.

For example, the electronic device 150 may include a semiconductor device that is an active device or a passive device. The active device may be a semiconductor chip in the form of an integrated circuit IC in which hundreds to millions of devices are integrated into one chip. In addition, the semiconductor device may be a logic chip, a memory chip, etc. For example, the logic chip may be a graphics processor (GPU), a central processor (CPU), a digital signal processor, an encryption processor, a microprocessor, an analog-to-digital converter, etc.

In addition, the memory chip to which the embodiment is applied may be a stack memory such as HBM. In addition, the memory chip may include a volatile memory such as DRAM, a non-volatile memory such as ROM, a flash memory, etc.

In addition, the semiconductor package may be a smart phone, a personal digital assistant, a digital video camera, a digital still camera, a vehicle, a high-performance server, a network system, a computer, a monitor, a tablet, a laptop, a netbook, a television, a video game, a smart watch, an automotive, etc. However, it is not limited thereto, and it is obvious that it may be any other electronic device that processes data.

In addition, the electronic device 150 may be a power semiconductor including a drain electrode, a semiconductor epi layer, a source electrode, and a gate electrode. For example, the epi layer of the power semiconductor to which the embodiment is applied may include Si or SiC, but is not limited thereto. If the electronic device 150 is a Power semiconductor including Si or SiC, the thermal expansion coefficient of the power semiconductor may be 4.0x10⁻⁶/°C to 17x10⁻⁶/°C, but is not limited thereto.

The electronic device 150 may be electrically connected to the substrate 110 through a connecting portion 155 including solder.

Next, the vapor chamber 130 may include an upper metal plate 131, a hollow structure 135, and a lower metal plate 133. The upper metal plate 131 and the lower metal plate 133 may be bonded at both ends, and a hollow structure 135 may be disposed between them. In FIG. 2, one side of the upper metal plate 131 is illustrated to have a slope, but is not limited thereto.

For example, the upper metal plate 131 of the vapor chamber 130 of the embodiment may be made of a material with excellent ductility, such as Cu, so that the upper metal plate 131 may be folded and joined to the lower metal plate 133.

In addition, the vapor chamber 130 of another embodiment may have a structure in which a middle metal plate (not shown) in which a hollow structure 135 is formed is provided, and the middle metal plate is interposed between the upper metal plate 131 and the lower metal plate 133 and then joined.

Referring to FIG. 2, the lower metal plate 133 of the vapor chamber 130 of the embodiment may include a plurality of plates. In detail, the lower metal plate 133 may include a first plate 136, a second plate 137, and a third plate 138 that are disposed sequentially in a vertical direction. The lower metal plate 133 may be formed through a metal bonding or sintering process. In addition, the first plate 136 and the third plate 138 may include the same material. In addition, the first plate 136 and the third plate 138 may include the same material as the upper metal plate 131. For example, the first plate 136, the third plate 138, and the upper metal plate 131 may include copper, but are not limited thereto. When the upper metal plate 131, the first plate, and the third plate 138 include copper, the thermal expansion coefficient may be 17×10⁻⁶/°C, but is not limited thereto.

In addition, the second plate 137 may include a different material from the first plate 136 and the third plate 138. In detail, the second plate 137 may include a metal material or a ceramic material.

For example, when the second plate 137 may include a metal material, the thermal expansion coefficient of the metal material of the second plate 137 may be less than the thermal expansion coefficients of the metal materials of the first plate 136 and the third plate 138.

In addition, the thermal expansion coefficient of the metal material of the second plate 137 may be greater than the thermal expansion coefficient of the electronic device 150. Accordingly, the metal material of the second plate 137 may be a metal material having a thermal expansion coefficient within a range of 4.0x10⁻⁶/°C to 17x10⁻⁶/°C, and for example, the second plate 137 may include, but is not limited to, gold Ag, iron Fe, nickel Ni, platinum Pt, molybdenum Mo, or tungsten W, etc. The second plate 137 may form a metal bond with the first plate 136 and the third plate 138.

In addition, the second plate 137 may include a ceramic material, and in this case, the ceramic material of the second plate 137 may be a ceramic material having a thermal expansion coefficient within a range of 4.0x10⁻⁶/°C to 17x10⁻⁶/°C, and for example, the second plate 137 may include an inorganic material such as Al₂O₃, ZrO₂, ALN, Y₂O₃, etc., but is not limited thereto.

Accordingly, the embodiment can reduce the difference in the thermal expansion coefficient between the vapor chamber 130 and the electronic device 150 since the thermal expansion coefficient of the second plate 137 of the lower metal plate 133 is less than the thermal expansion coefficients of the first plate 136 and the third plate 138. Therefore, the embodiment can prevent thermal deformation of the vapor chamber 130 and the electronic device 150 as the difference in thermal expansion coefficient between the vapor chamber 130 and the electronic device 150 becomes smaller.

In addition, the embodiment may include a post 118 disposed on the substrate 110, and the post 118 can be disposed between the substrate 110 and the vapor chamber 130. In addition, the post 118 can be disposed to overlap the electronic device 150 in a horizontal direction.

The post 118 and the vapor chamber 130 can be bonded through a third adhesive layer 119. In addition, the post 118 can include a metal having high strength. The post 118 can prevent warpage of the vapor chamber 130 by contacting both ends of the vapor chamber 130, and has a technical effect of protecting the electronic device 150 from external contaminants such as moisture and dust.

The embodiment may include a post 118 disposed on a substrate 110, and a vapor chamber 130 can be disposed on the post 118 and the electronic device 150, and the vapor chamber 130 can be disposed in contact with the electronic device 150.

The embodiment has a special technical effect that can solve the problem of technical contradiction that cracks or voids may occur in the metal adhesive layer due to a difference in thermal expansion coefficient by controlling the thermal expansion coefficient of the third plate 138 of the vapor chamber 130 in contact with the electronic device 150 while efficiently transferring heat generated from the electronic device upward by using a metal adhesive layer including a metal material as the first adhesive layer 140.

For example, the first adhesive layer 140 may include, but is not limited to, a Sn alloy adhesive layer, an In alloy adhesive layer, an Al alloy adhesive layer, etc. For example, the first adhesive layer 140 may include, but is not limited to, a SnxAgyCuz alloy adhesive layer, an InxAgy alloy adhesive layer, etc.

Also, according to the embodiment, when manufacturing the vapor chamber 130, a material capable of reducing the difference in the coefficient of thermal expansion CTE at the surface in contact with the electronic device 150 is included, and due to the reduction in the difference in the coefficient of thermal expansion, thermal deformation between the electronic device and the vapor chamber 130 due to temperature change can be minimized, so that reliability and heat dissipation efficiency can be significantly improved by using a metal-based adhesive layer with high hardness and high thermal conductivity without delamination, thereby providing a complex technical effect.

Next, FIG. 3 is a drawing showing in detail the vapor chamber 130 for a semiconductor package module according to the embodiment of FIG. 2. Referring to FIG. 3, the vapor chamber 130 may include an upper metal plate 131, a hollow structure 135, and a lower metal plate 133. The vapor chamber according to the embodiment may include a plurality of trench structures 139 or a plurality of holes, and the plurality of trench structures 139 or the plurality of holes may be filled with other materials.

For example, a working fluid inlet may be formed on one side of a hollow structure 135, a working fluid may be injected into the hollow structure, and the fluid inlet may be closed. The working fluid may be, but is not limited to, acetone, methanol, ethanol, or deionized water (DI-water.

According to an embodiment, as heat generated from the electronic device is efficiently transferred to the lower metal plate 133 through the first adhesive layer 140, which is a metal adhesive layer, the working fluid may vaporize, absorb latent heat of vaporization, move toward the upper metal plate 131, and condense into a liquid while releasing latent heat of vaporization. The condensed working fluid may be absorbed by the trench structure 139 of the hollow structure and move toward the lower metal plate 133.

In addition, in the embodiment, the lower metal plate 133 may include a first plate 136, a second plate 137 disposed on the first plate 136, and a third plate 138 disposed on the second plate 137. The second plate 137 may be interposed between the first plate 136 and the third plate 138.

The upper metal plate 131 and the lower metal plate 133 may include the same material. In addition, the first plate 136 and the third plate 138 may include the same material. The upper metal plate 131, the first plate 136, and the third plate 138 may include the same metal material, for example, copper Cu, but are not limited thereto.

In addition, according to the embodiment, there is a complex technical effect that can further improve reliability by rapidly dissipating heat generated from the electronic device to further improve heat dissipation performance and preventing warpage of the vapor chamber in contact with the electronic device.

For example, as shown in FIG. 3, the first thickness T1 of the first plate 136 in the lower metal plate 133 may be greater than the third thickness T3 of the third plate 138. In addition, the first thickness T1 of the first plate 136 may be greater than the second thickness T2 of the second plate 137.

In addition, the second plate 137 may be disposed to be biased toward the upper region based on the horizontal center within the lower metal plate 133.

The second plate 137 may be disposed to be closer to the upper surface than the lower surface of the lower metal plate 133. Therefore, the embodiment has a technical effect that the heat generated from the electronic device 150 can be rapidly dissipated and the heat dissipation performance can be further improved by forming the first plate 136 adjacent to the electronic device thicker than the third plate 138.

In addition, the first thickness T1 of the first plate 136 may be greater than the third thickness T3 of the third plate 138 so that the thermal expansion coefficient of the metal material disposed on the upper side of the second plate 137 and the thermal expansion coefficient of the metal material disposed below the second plate 137 can be symmetrical with respect to the second plate 137 having a relatively large thermal expansion coefficient. Accordingly, the embodiment has a technical effect that the upper and lower thermal expansion coefficients of the vapor chamber 130 can be symmetrical with respect to the second plate 137, thereby preventing the warpage problem of the vapor chamber and preventing the peeling of the first adhesive layer, thereby further improving the reliability.

FIG. 4 is a drawing showing a vapor chamber for a semiconductor package module according to the second embodiment. Referring to FIG. 4, the vapor chamber according to the second embodiment may include an upper metal plate 131, a lower metal plate 133, and a middle metal plate 132.

The upper metal plate 131, the middle metal plate 132, and the lower metal plate 133 may include the same metal, for example, copper Cu, but is not limited thereto. In addition, the upper metal plate 131, the middle metal plate 132, and the lower metal plate 133 may have a flat shape. In addition, the middle metal plate 132 may be interposed between the upper metal plate 131 and the lower metal plate 133.

The lower metal plate 133 and the middle metal plate 132 may be joined through metal bonding. In addition, the intermediate metal plate 132 and the upper metal plate 131 may be joined through metal bonding.

In addition, a hollow structure 135 may be formed within the intermediate metal plate 132. The hollow structure 135 may be formed by arranging the intermediate metal plate 132 at both ends of the vapor chamber with the hollow structure 135 therebetween. In addition, the hollow structure 135 may be formed by etching the intermediate metal plate 132 and may have a flow path shape.

The thickness of the hollow structure 135 may be the same as the thickness of the intermediate metal plate 132. In addition, the hollow structure 135 may be in contact with the lower surface of the upper metal plate 131 and the upper surface of the lower metal plate 133, and may be overlapped with the intermediate metal plate 132 in a horizontal direction.

In addition, a trench structure 139 may be disposed within the hollow structure 135. The thickness of the trench structure 139 may be the same as the thickness of the intermediate metal plate 132, and may be overlapped with the intermediate metal plate 132 in the horizontal direction.

In addition, the lower metal plate 133 may include a first plate 136, a second plate 137, and a third plate 138. The first plate 136 and the third plate 138 may include the same material. In addition, the second plate 137 may include a different material from the first plate 136 and the third plate 138. In detail, the second plate 137 may include a material having a smaller thermal expansion coefficient than the materials of the first plate 136 and the third plate 138.

Accordingly, the embodiment has a technical effect of minimizing thermal deformation of the vapor chamber and the electronic device (not shown) by forming the first plate 136 of the vapor chamber adjacent to the electronic device (not shown) to have a small coefficient of thermal expansion, thereby reducing the difference in thermal expansion coefficient between the electronic device and the vapor chamber.

In addition, the embodiment has a technical effect of minimizing the difference in thermal expansion coefficient between the vapor chamber 130 and the electronic device, thereby preventing the peeling of the adhesive layer disposed between the vapor chamber 130 and the electronic device, thereby enabling the use of a metal adhesive layer, thereby improving reliability and heat dissipation efficiency.

In addition, the first thickness T1 of the first plate 136 may be formed to be thicker than the third thickness T3 of the third plate 138. Accordingly, the embodiment has a technical effect of further improving heat dissipation performance by rapidly dissipating heat generated from the electronic device 150 as the first plate 136 adjacent to the electronic device is formed thicker than the third plate 138.

FIG. 5 is a drawing showing a vapor chamber for a semiconductor package module according to the third embodiment. Referring to FIG. 5, the third embodiment may further include a thermal conductive plug 142 in the lower metal plate 133.

The thermal conductive plug 142 may be disposed to penetrate the second plate 137 of the lower metal plate 133. The second plate 137 may include a grid shape having upper and lower penetration holes, but is not limited thereto. In addition, the second plate 137 may include a thermal conductive plug 142 filling the upper and lower penetration holes.

The thermal conductive plug 142 may be in contact with the upper surface of the first plate 136. In addition, the thermal conductive plug 142 may be in contact with the lower surface of the third plate 138. In addition, the thermal conductive plug 142 may include a plurality of pieces that are disposed to be spaced apart in the horizontal direction within the second plate 137. The thickness of the thermal conductive plug 142 may be the same as the second thickness T2 of the second plate 137.

The thermal conductive plug 142 material that fills the hole of the second plate 137 may be filled with a metal material having higher thermal conductivity than the material of the second plate 137. For example, the thermal conductive plug 142 may be filled with the same material as the first plate 136 or the third plate 138, but is not limited thereto. For example, the thermal conductive plug 142 may be filled with copper Cu. Accordingly, heat generated from the electronic device can be efficiently transferred from the first plate 136 to the third plate 138 through the second plate 138 and the thermal conductive plug 142. Accordingly, there is a technical effect that heat conduction can be improved from the first plate 136 to the third plate 138, thereby further improving heat dissipation performance.

In addition, according to the third embodiment, the second plate 137 of the vapor chamber may include a composite material having a thermal expansion coefficient higher than that of the electronic device, thereby minimizing deformation of the vapor chamber 130 due to a decrease in the thermal expansion coefficient difference, thereby further improving reliability and further improving heat dissipation performance.

FIG. 6 is a drawing showing a vapor chamber for a semiconductor package module according to the fourth embodiment. Referring to FIG. 6, the fourth embodiment may have a first fin 145-1 disposed on the upper metal plate 131. The first fin 145-1 may include a rod shape extending upward from the upper surface of the upper metal plate 131. The first fin 145-1 may include the same material as the upper metal plate 131, for example, copper Cu, but is not limited thereto.

The first fin 145-1 may be formed by etching the upper surface of the upper metal plate 131. In addition, the first fin 145-1 may be formed on the upper surface of the upper metal plate 131 through a skiving method.

In addition, the first fin 145-1 may include a plurality of fins disposed spaced apart from each other. Accordingly, the fourth embodiment has a technical effect that heat generated from an electronic device (not shown) can be effectively transferred to the vapor chamber 130 by having a second plate 137 having a lower thermal expansion coefficient than the first plate 136 and the third plate 138, and heat dissipation performance can be maximized through the first fin 145-1.

In addition, the fourth embodiment may further include a thermal conductive plug 142 disposed in the second plate 137 in the third embodiment.

Next, FIG. 7 is a drawing showing a vapor chamber for a semiconductor package module according to the fifth embodiment. Referring to FIG. 7, the fifth embodiment may include a second fin 145-2 disposed on an upper metal plate 131.

The second fin 145-2 may include a plurality of fins disposed spaced apart from each other. The second fin 145-2 may have a cross-sectional area that increases as its height increases, thereby improving heat dissipation performance. At this time, the heights of the plurality of second fins 145-2 may be different from each other. Accordingly, the embodiment may include a concave portion 147 that is concave in the upper direction of the plurality of second fins 145-2 toward the upper metal plate 131. The plurality of second fins 145-2 may have the lowest height or may not be located in the central region. In addition, the plurality of second fins 145-2 may have a height that increases as the second fins 145-2 go along both ends of the upper metal plate 131. The heights of the plurality of second fins 145-2 may gradually decrease along the horizontal direction and then gradually increase. Accordingly, the concave portion 147 may have a virtual curvature.

The horizontal center of the vapor chamber 130 may be the area closest to the electronic device not shown and may be the area where the most heat is transferred. In addition, the horizontal center of the concave portion 147 may be the same as the horizontal center of the vapor chamber 130.

Therefore, the fifth embodiment can control the difference in heat dissipation performance along the horizontal direction of the vapor chamber 130 by forming the height of the second fin 145-2 smaller in the area adjacent to the electronic device. Accordingly, the embodiment has a special technical effect of controlling the heat dissipation performance less in the area adjacent to the electronic device to actively vaporize the working fluid, and improving the heat dissipation performance at both ends of the vapor chamber 130 to actively condense the vaporized working fluid, thereby promoting the convection phenomenon of the fluid within the vapor chamber 130 to improve the heat dissipation performance.

In addition, the fifth embodiment may further include a thermal conductive plug 142 disposed within the second plate 137 in the third embodiment.

Next, FIG. 8 is a drawing showing a semiconductor package module including a vapor chamber for a semiconductor package module according to the sixth embodiment. The sixth embodiment may further include a second vapor chamber 180 and a heat sink 190 in the semiconductor package module including the vapor chambers of the first to fifth embodiments.

Referring to FIG. 8, a second vapor chamber 180 may be disposed on the vapor chamber 130. The vapor chamber 130 and the second vapor chamber 180 may be adhered to each other through a second adhesive layer 170. In addition, the second vapor chamber 180 may be larger than the horizontal width of the vapor chamber 130. The second adhesive layer 170 may include, but is not limited to, a metal adhesive layer.

In addition, a heat sink 190 may be disposed on the second vapor chamber 180. Accordingly, the third embodiment has a technical effect of improving heat dissipation performance by spreading the heat transferred through the vapor chamber 130 to a wider area.

The second vapor chamber 180 may adopt the technical features of the vapor chamber 130 described above. For example, the second vapor chamber 180 may include a fourth plate, a fifth plate, and a sixth plate disposed in a vertical direction, and a hollow structure may be disposed on the fifth plate. The fourth plate may be formed thicker than the thicknesses of the fifth plate and the sixth plate, but is not limited thereto.

Next, FIGS. 9A to 9C are graphs showing the package temperature, the operating frequency of the CPU chip, and the power consumption of the processor over time for the embodiment E and the comparative example R, respectively.

The embodiment E and the comparative example R may be, for example, a CPU chip, but are not limited thereto. The CPU chip of the embodiment E of FIGS. 9A to 9C may include a semiconductor package module including a vapor chamber according to the embodiment of FIGS. 2 to 8.

The CPU chip of the embodiment E has significantly improved heat dissipation performance as shown in FIG. 9A when the semiconductor package module including the vapor chamber according to the embodiment of FIGS. 2 to 8 is applied, so that the temperature of the semiconductor chip is maintained lower, and even when the temperature rises for operation, it shows an effect of quickly dropping to a lower temperature.

Specifically, when the CPU chip is operated, the temperature of the package rapidly increases due to the heat generated by the CPU chip. When the CPU chip stops operating, the temperature of the semiconductor package module decreases, and when the CPU chip is operated again, the peak temperature is reached again.

Meanwhile, referring to FIG. 9A, in the case of embodiment E, it can be confirmed that the temperature decreases faster than the comparative example R when the CPU chip is driven and stopped by applying the semiconductor package module including the vapor chamber according to the embodiment. In addition, while the embodiment E and the comparative example R reach the same temperature when the CPU chip is driven, the embodiment E has a special technical effect that it can exhibit higher performance and higher efficiency by expressing a higher clock frequency and power consumption while maintaining the same driving temperature due to the very efficient heat dissipation efficiency as shown in FIGS. 9B and 9C.

In addition, according to the embodiment, the more effective heat dissipation structure in contact with the semiconductor provides a great effect on heat diffusion, and even if the size or performance of the heat dissipation structure of the subsequent structure is small or low, it can provide the same level of final heat dissipation performance, thereby also having the effect of reducing the overall cost.

Specifically, referring to FIG. 9B, when the CPU chip is driven, the temperature of the CPU chip increases with the driving time, so in order to prevent the chip from being damaged by the temperature increasing further, there is an underclock function that forcibly lowers the clock frequency of the CPU chip.

For example, in the case of the comparative example R, the clock frequency of the CPU chip is lowered to extend the life of the CPU chip because the heat dissipation efficiency is low, and at this time, in the comparative example R, the clock frequency decrease is large, so there is a problem that the performance of the CPU chip is significantly reduced.

On the other hand, in the case of the embodiment E, when the semiconductor package module including the vapor chamber according to the embodiment is applied, the heat dissipation performance can be significantly improved, so that the decrease in the clock frequency of the CPU chip is almost zero or very small compared to the comparative example R, so there is a special technical effect that can maximize the performance of the CPU chip.

Also, referring to FIG. 9C, when the temperature of the CPU chip increases over time when the CPU chip is driven, the power consumption is forcibly lowered to suppress the temperature increase.

For example, in the case of Comparative Example R, since the heat dissipation efficiency is low, the power of the CPU chip is lowered to extend the life of the CPU chip, and in Comparative Example R, the processor power reduction is very large, so there is a problem that the performance of the CPU chip is significantly reduced.

On the other hand, in Embodiment E, the heat dissipation performance can be significantly improved when the semiconductor package module including the vapor chamber is applied, so the reduction in power consumption over time is very small compared to Comparative Example R, so there is a special technical effect that can maintain high performance of the CPU chip.

Although the above has been described with reference to the embodiments of the present invention, those skilled in the art will easily understand that the present invention can be variously modified and changed within the scope that does not depart from the scope of the present invention described in the scope of the following patent claims.

### [Reference of signs]

| | | | |
|---|---|---|---|
| 60: | metal plate | 70, 170: | second adhesive layer |
| 80, 180: | vapor chamber | 90, 190: | heat sink |
| 110: | substrate | 118: | post |
| 119: | third adhesive layer | 130: | vapor chamber |
| 131: | upper metal plate | 132: | middle metal plate |
| 133: | lower metal plate | 135: | hollow structure |
| 136: | first plate | 137: | second plate |
| 138: | third plate | 139: | trench structure |
| 140: | adhesive layer | 142: | thermal conductive plug |
| 145-1: | first pin | 145-2: | second Pin |
| 147: | Recessed portion | 150: | Electronic device |
| 155*:* | Connection portion | E: | Example |
| R: | Comparative example | | |

## Claims

1. A vapor chamber for a semiconductor package module, the vapor chamber comprising:
a lower metal plate, a middle metal plate, and an upper metal plate disposed sequentially;
wherein a hollow structure is disposed within the middle metal plate,
wherein the lower metal plate comprises a first plate, a second plate, and a third plate disposed sequentially, and
wherein a coefficient of thermal expansion of the second plate is less than that of the first plate or that of the third plate.

2. The vapor chamber according to claim 1, wherein the coefficient of thermal expansion of the second plate is less than that of the first plate and that of the third plate.

3. The vapor chamber according to claim 1 or claim 2, wherein a thickness of the hollow structure is the same as that of the middle metal plate.

4. The vapor chamber according to any one of claims 1 to 3, wherein one of the upper metal plate or the lower metal plate comprises a flat shape.

5. The vapor chamber according to any one of claims 1 to 4, wherein each of the upper metal plate and the lower metal plate comprises a flat shape.

6. The vapor chamber according to any one of claims 1 to 5, further comprising a plurality of first fins disposed on the upper metal plate.

7. The vapor chamber according to claim 6, wherein each of the plurality of first fins has a different height.

8. The vapor chamber according to claim 6 or 7, wherein a height of the first fin located in a center of the upper metal plate is lower than that of the first fin located in an outer portion of the upper metal plate.

9. The vapor chamber according to any one of claim 6, 7 or 8, wherein the plurality of first fins comprise a concave portion recessed in a direction of the upper metal plate.

10. The vapor chamber according to any one of claims 1 to 9, wherein a thickness of the first plate is greater than that of the third plate.

11. The vapor chamber according to any one of claims 1 to 10, wherein the lower metal plate further comprises a thermal conductive plug disposed within the second plate.

12. A semiconductor package module including a vapor chamber, the semiconductor package module comprising:
a substrate;
an electronic device disposed on the substrate;
a vapor chamber disposed on the electronic device; and
a first adhesive layer disposed between the electronic device and the vapor chamber,
wherein the vapor chamber comprises the vapor chamber according to any one of claims 1 to 11.

13. The semiconductor package module according to claim 12, wherein the first adhesive layer comprises a metal material.

14. The semiconductor package module according to the claim 12 or 13, wherein the lower plate further comprises a thermal conductive plug within the second plate,
wherein the thermal conductive plug has higher thermal conductivity than the second plate, and
wherein the thermal conductive plug has a lower thermal expansion coefficient than the second plate.

15. A power conversion device comprising the semiconductor package module according to any one of claims 12, 13 or 14.
